Europäisches Patentamt

European Patent Office

Office européen des brevets

(19)

(11) Veröffentlichungsnummer: **0 196 627**
**B1**

(12) **EUROPÄISCHE PATENTSCHRIFT**

(45) Veröffentlichungstag der Patentschrift: **11.07.90**

(21) Anmeldenummer: **86104211.7**

(22) Anmeldetag: **26.03.86**

(51) Int. Cl.⁵: **H 03 F 3/30, H 03 F 3/68**

(54) Integrierte Verstärkerschaltung.

(30) Priorität: **27.03.85 DE 3511189**

(43) Veröffentlichungstag der Anmeldung:
**08.10.86 Patentblatt 86/41**

(45) Bekanntmachung des Hinweises auf die
Patenterteilung:
**11.07.90 Patentblatt 90/28**

(84) Benannte Vertragsstaaten:
**AT DE FR GB IT NL**

(56) Entgegenhaltungen:
EP-A-0 106 088

PATENTS ABSTRACTS OF JAPAN, Band 5, Nr.
59 (E-53)731r, 22. April 1981; & JP - A - 56 8911
(TOUKOU K.K.) 29.01.1981
DER ELEKTRONIKER, Band 15, Nr. 11,
November 1976, Seiten EL12 - EL14, Aarau, CH;
U. LACHMANN: "Ein NF-Leistungsverstärker in
Brückenschaltung mit Mehrfach-
Operationsverstärkern"

(73) Patentinhaber: **Siemens Aktiengesellschaft**
**Wittelsbacherplatz 2**
**D-8000 München 2 (DE)**

(72) Erfinder: **Lenz, Michael, Dipl.-Ing.**
**Fischbachauerstrasse 3**
**D-8000 München 90 (DE)**

(56) Entgegenhaltungen:
ELECTRONIQUE APPLICATIONS, Nr. 32,
Oktober-November 1983, Seiten 55-56; "Fiche
Technique LM2878", Evry, FR; "Circuits intégrés
linéaires. Double amplificateur BF 2 X 5 W"

**Beschreibung**

Die Erfindung betrifft eine integrierte Verstärkerschaltung nach dem Oberbegriff des Patentanspruchs 1.

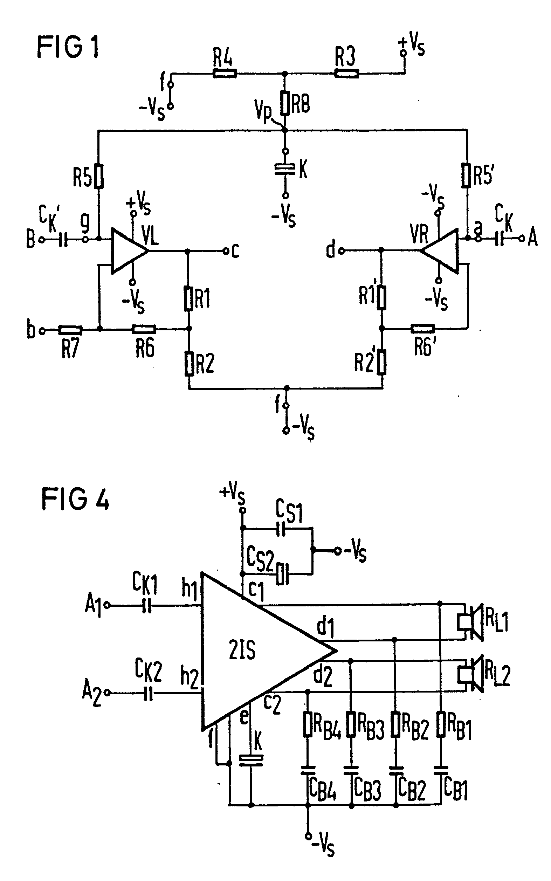

Eine Schaltung dieser Art ist aus der DE—A—32 34 400 bekannt und in Fig. 1 dargestellt. Sie enthält die beiden—einander im Aufbau gleichen—Operationsverstärker VL und VR, deren nichtinvertierende Eingänge, wie üblich, durch das Zeichen "+" und deren invertierende Eingänge durch das Zeichen "−" gekennzeichnet sind. Der Ausgang c des Operationsverstärkers VL ist über die Reihenschaltung zweier Widerstände R1 und R6 mit dem invertierenden Eingang dieses Operationsverstärkers verbunden. Der zwischen den beiden Widerständen R1 und R6 gegebene Verbindungspunkt ist außerdem über einen Widerstand R2 mit einer Klemme f der integrierten Verstärkerschaltung verbunden, die an ein Bezugspotential −V$_S$ angeschlossen ist. Die Widerstände R1 und R2 stellen einen ohmschen Spannungsteiler dar und bilden in Verbindung mit dem Widerstand R6 ein reelles Gegenkopplungsnetzwerk für den Operationsverstärker VL. Außerdem ist der invertierende Eingang des Operationsverstärkers VL über einen Vorwiderstand R7 mit der Klemme b verbunden, an der ein Signal für den invertierenden Betrieb des Verstärkers VL eingespeist werden kann.

In entsprechender Weise ist bei dem anderen Operationsverstärker VR der Signalausgang d über die Reihenschaltung zweier, einen ohmschen Spannungsteiler bildende Widerstände R1′ und R2′ mit der Klemme f und mit dem Bezugspotential −V$_S$ verbunden. Der Teilerpunkt des ohmschen Spannungsteilers ist über den Widerstand R6′ an den invertierenden Eingang des Operationsverstärkers VR angeschlossen.

Die nichtinvertierenden Signaleingänge g und a der beiden Operationsverstärker VL und VR liegen, z.B. unter Vermittlung je eines zur Außenbeschaltung der integrierten Verstärkerschaltung gehöhrenden Kondensators C$_K$′ und C$_K$, an den Klemmen B und A, über die Eingangssignale eingespeist werden können. Außerdem sind die beiden nichtinvertierenden Eingänge über je einen Versorgungswiderstand R5 und R5′ an einen Knotenpunkt angeschlossen, der mit einem heruntergeteilten Versorgungspotential V$_P$ versorgt wird und mit der Anschlußklemme e der integrierten Verstärkerschaltung verbunden ist. Das heruntergeteilte Versorgungspotential V$_P$ wird über einen ohmschen Zwischenwiderstand R8 vom Teilerpunkt des aus den beiden Widerständen R3 und R4 gebildeten ohmschen Spannungsteilers abgeleitet. Dabei ist der Widerstand R3 mit seinem freien Anschluß an das Versorgungspotential +V$_S$ und der Widerstand R4 mit seinem freien Anschluß über die Anschlußklemme f der integrierten Verstärkerschaltung an das Bezugspotential −V$_S$ angeschlossen.

Zur Glättung des Potentials V$_P$ kann der an der Klemme e der integrierten Verstärkerschaltung liegende Knotenpunkt über einen Kondensator K an das Bezugspotential −V$_S$ angeschlossen werden. Die beiden Operationsverstärker VL und VR erhalten ihre Betriebsspannung jeweils durch den Anschluß einer Klemme an das Versorgungspotential +V$_S$ und einer Klemme an das Bezugspotential −V$_S$. Aus den DE—A—32 35 289 ist bekannt, die Ausgangsstufen der Operationsverstärker über eine separate Anschlußklemme direkt mit dem Bezugspotential −V$_S$ zu verbinden, während die Eingangsstufen der Operationsverstärker über die in Verbindung mit den ohmschen Spannungsteilern erwähnte Klemme f an das Bezugspotential −V$_S$ angeschlossen werden.

Beim Betrieb der Verstärkerschaltung als Stereoverstärker werden die Operationsverstärker gleichphasig gesteuert und die Signalausgänge der Operationsverstärker arbeiten über die Klemmen c und d auf jeweils ein Lastelement, z.B. je einen Lautsprecher, dessen anderer Anschluß mit dem Bezugspotential −V$_S$ verbunden ist. Beim Betrieb der Verstärkerschaltung als Brückenverstärker werden die Operationsverstärker gegenphasig gesteuert und die Signalausgänge der Operationsverstärker arbeiten über die Klemmen c und d auf die beiden Anschlüsse eines einzigen Lastelementes.

Die in Fig. 1 angegebene Schaltung ist, mit Ausnahme der Kondensatoren, integrierfähig. Für die Dimmensionierung der Widerstände können die in der DE—A—32 34 400 angegebenen Bemessungsregeln herangezogen werden. Sie benötigt allerdings ein Spezialgehäuse, weil der Betrieb der Schaltung nur über die an die neun Anschlußpins anzuschließende Außenbeschaltung möglich ist.

Der Erfindung liegt die Aufgabe zugrunde, eine als Brückenverstärker zu betreibende integrierte Verstärkerschaltung anzugeben, die zum Anschluß der für den Betrieb notwendigen Außenbeschaltung nur sieben Anschlußpins benötigt. Weiterhin soll sich die integrierte Verstärkerschaltung für einen Stereoverstärker verwenden lassen, der gegenüber der in Fig. 1 angegebenen Schaltung eine erheblich größere Ausgangsleistung bietet.

Diese Aufgabe wird bei einer Schaltungsanordnung der eingangs genannten Art erfindungsgemäß durch die Merkmale des kennzeichnenden Teil des Patentanspruchs 1 gelöst.

Die erfindungsgemäße integrierte Verstärkerschaltung läßt sich beim Betrieb als Brückenschaltung in ein siebenpoliges Gehäuse, z.B. in das Gehäuse TO 220/7 integrieren. Die noch notwendige geringe Außenschaltung der erfindungsgemäßen integrierten Verstärkerschaltung und der niedrige Wärmewiderstand des Leistungsgehäuses TO 220/7 bieten weitere anwenderfreundliche Vorteile. Grundgedanke der Erfindung ist es, daß in der Schaltung nach Fig. 1 die Operationsverstärker im interessierenden niederfrequenten Bereich, d.h. bei Frequenzen unter 100 kHz, eine gegenüber dem Widerstand R5 bzw. R5′ wesentlich höhere und rein reelle Eingangsimpedanz besitzen. Beim Betrieb als Brückenverstärker, d.h. beim invertierenden Betrieb des Operationsverstärkers VL und dem nichtinvertierenden Betrieb des Operationsverstärkers VR, ist deshalb der Kondensator $C_K'$ nicht erforderlich da die Klemme B nicht auf Bezugspotential gelegt werden muß. Mit dem Kondensator $C_K'$ kann damit auch die Klemme g der integrierten Verstärkerschaltung entfallen.

Ausgestaltungen des Erfindungsgedankens sind in Unteransprüchen gekennzeichnet.

Die Erfindung wird im folgenden anhand von in den Figuren der Zeichnung dargestellten Ausführungsbiespielen näher erläutert.

Es zeigt:

Fig. 2 die erfindungsgemäße integrierte Verstärkerschaltung mit einer für ein Anwendungsbeispiel erforderlichen Außenbeschaltung,

Fig. 3 eine Ausgestaltung für einen der beiden Operationsverstärker und

Fig. 4 ein Ausführungsbeispiel für eine unter Verwendung der erfindungsgemäßen integrierten Verstärkerschaltung realisierte Stereoverstärkerschaltung mit Außenbeschaltung.

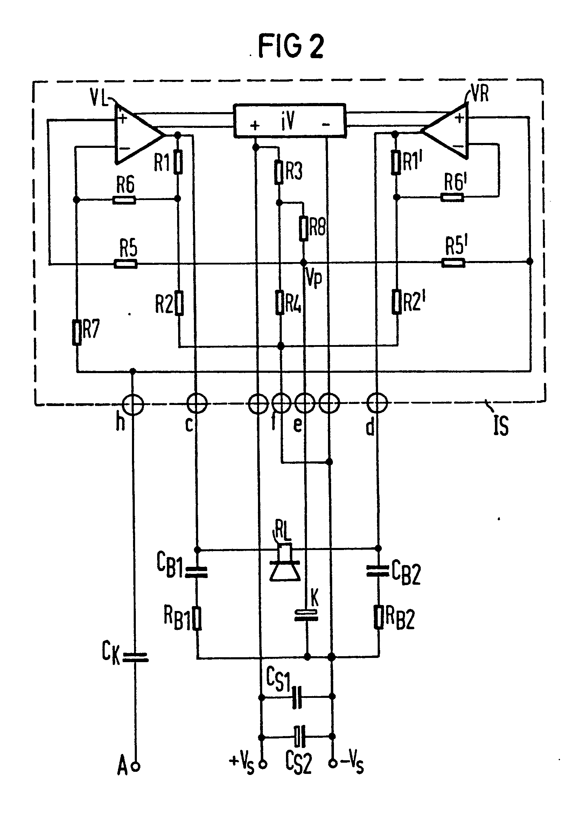

In der in Fig. 2 dargestellten Ausgestaltung einer erfindungsgemäßen integrierten Verstärkerschaltung sind gleiche Elemente wie in Fig. 1 mit gleichen Bezugszeichen versehen. Die integrierte Verstärkerschaltung ist in dem gestrichelt umrandeten Block IS enthalten. Die beiden Operationsverstärker VL und VR mit ihren nichtinvertierenden und invertierenden Eingängen sowie die aus den Widerständen R1, R2 und R6 bzw. R1', R2' und R6' bestehenden reellen Gegenkopplungen entsprechen der Fig. 1. Ein die Fußpunkte der beiden Spannungsteiler, d.h. die Widerstände R2 und R2' verbindender erster Knotenpunkt ist mit den Anschlußklemme f, die Ausgänge der Operationsverstärker VL und VR mit den Anschlußklemmen c und d der integrierten Verstärkerschaltung IS verbunden.

An die beiden nicht bezeichneten Anschlußklemmen wird die Versorgungsspannung mit dem Versorgungspotential $+V_s$ und dem Bezugspotential $-V_s$ angeschlossen. Über die nicht näher erläuterten internen Verbindungen iV wird die an den nicht bezeichneten Anschlußklemmen liegende Versorgungsspannung den beiden Operationsverstärkern VL und VR zugeführt. An dem im Block iV mit "+" bezeichneten Anschluß liegt der zum ersten Kontenpunkt und zur Anschlußklemme f geschaltete ohmsche Spannungsteiler aus den Widerständen R3 und R4, an dessen Teilerpunkt über den Zwischenwiderstand R8 ein an einem zweiten Knotenpunkt liegendes Potential $V_P$ abgegriffen wird. Dieser zweite Knotenpunkt ist weiterhin mit der Anschlußklemme e der integrierten Schaltung IS und über die beiden Versorgungswiderstände R5 und R5' mit den nichtinvertierenden Eingängen der Operationsverstärker VL und VR verbunden.

Über den Widerstand R7 ist der invertierende Eingang des Operationsverstärkers VL mit dem nichtinvertierenden Eingang des Operationsverstärkers VR und mit der Anschlußklemme h der integrierten Schaltung, die die Signaleingangsklemme darstellt, verbunden.

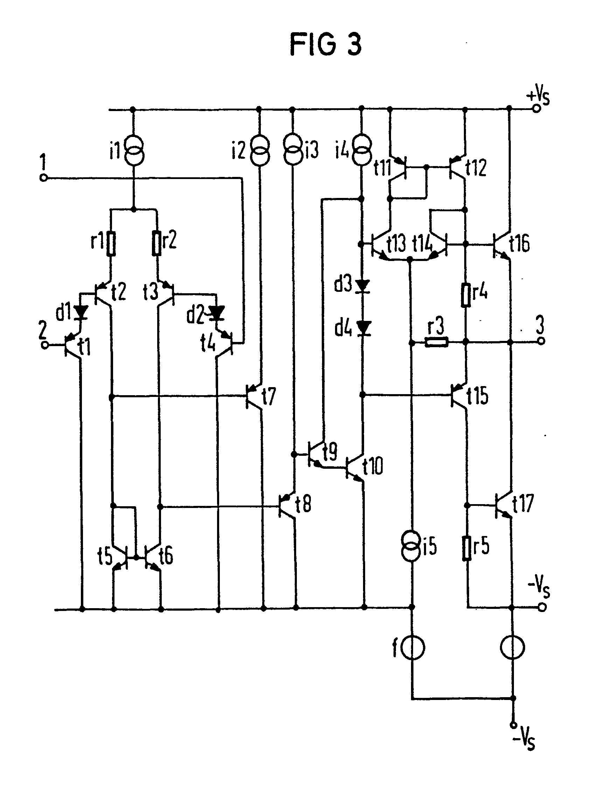

Das nicht näher dargestellte interne Netzwerk iV, das die Spannungsversorgung für die Operationsverstärker VL und VR gewährleistet, kann aus zwei Knotenpunkten bestehen, die die Anschlußleitungen für das Versorgungspotential und das Bezugspotential auf die beiden Operationsverstärker verteilen. Wie in Fig. 3 näher erläutert werden wird, werden an den Knoten für das Bezugspotential $-V_s$ in einer anderen Ausführungsform nur die Ausgangsstufen der Operationsverstärker angeschlossen, während, wie in Fig. 2 nicht dargestellt, die Eingangsstufen der Operationsverstärker über je eine zusätzliche Leitung mit dem ersten Knotenpunkt und der Anschlußklemme f verbunden sind.

Die Bemessung der Widerstände R1 bis R8 sowie R1', R2' R5' und R6' der integrierten Verstärkerschaltung kann nach der DE—OS 32 34 400 erfolgen. Mit den oben bezeichneten Widerständen ist die Außenbeschaltung der Operationsverstärker nahezu vollständig integriert.

Aufgrund der internen Verbindung der Signaleingangsklemme h der integrierten Schaltung IS mit dem invertierenden Eingang des Operationsverstärkers VL und dem nichtinvertierenden Eingang des Operationsverstärkers VR werden die beiden Operationsverstärker gegenphasig gesteuert und die integrierte Schaltung arbeitet als Brückenverstärker. Da die Schaltung für den niederfrequenten Bereich unter 100 kHz konzipiert ist, in dem die Eingangsimpedanz der Operationsverstärker reell und wesentlich höher als der Widerstand R5 ist, kann eine kapazitive Erdung des nichtinvertierenden Eingangs des Operationsverstärkers VL entfallen und eine damit eventuell verbundene Anschlußklemme. Ein durch den Widerstand R7 fließender Strom verschwindet dann, wenn die Offsetgrößen der übrigen Schaltung gegen Null gehen. In einer Serienfertigung der integrierten Schaltung IS streuen die Absolutbeträge der Ausgangsgleichspannungen stärker als bei einer Brückenverstärkerschaltung nach dem Stand der Technik; die für einen Brückenverstärker maßgebliche Differenzausgangsspannung wird dagegen bei einer erfindungsgemäßen integrierten Verstärkerschaltung kaum beeinflußt.

In Fig. 2 ist neben der integrierten Schaltung IS eine als Anwendungsbeispiel anzusehende Außenbeschaltung für einen als Lastelement $R_L$ vorgesehenen Lautsprecher angegeben. Dazu sind die mit den Ausgängen der Operationsverstärker verbundenen Anschlußklemmen c und d der integrierten Schaltung jeweils mit einem Anschluß des Lautsprechers $R_L$ verbunden. Zusätzlich liegt zwischen der Klemme c bzw. der Klemme d einerseits und dem Bezugspotential $-V_s$ andererseits je die Reihenschaltung eines Kondensators und eines Widerstandes, die durch die Elemente $C_{B1}$ und $R_{B1}$ sowie $C_{B2}$ und $R_{B2}$ bezeichnet sind. Von der Klemme e der integrierten Schaltung IS, die das Potential $V_P$ führt, ist ein Kondensator K ebenfalls zum Bezugspotential $-V_s$ geschaltet. Dieser Kondensator K dient zur Glättung der Spannung zwischen dem Konten-

punkt mit dem Potential $V_P$ und dem Bezugspotential $-V_S$ und bestimmt wesentlich die Einschalteigenschaften der integrierten Schaltung. Das Bezugspotential $-V_S$ und das Versorgungspotential $+V_S$ ist an zwei Klemmen anzuschließen, die ihrerseits mit den nichtbezeichneten Klemmen der integrierten Verstärkerschaltung IS verbunden sind. Zwischen den beiden Klemmen für das Versorgungs und das Bezugspotential liegen die Siebkondensatoren $C_{S1}$ und $C_{S2}$, die Versorgungsspannungspitzen und—schwankungen abblocken sollen. Der Anschluß der Signaleingangsklemme h an einen Signalgenerator erfolgt über einen Koppelkondensator $C_K$ und dessen freie Anschlußklemme A. Im Ausführungsbeispiel ist die an ein Potential anzuschließende Klemme f der integrierten Schaltung IS extern an das Bezugspotential $-V_S$ angeschlossen.

Ein Biespiel für die schaltungsgemäße Ausgestaltung der Operationsverstärker VL und VR ist in Fig. 3 angegeben. Die Schaltung ist in komplementärer Bipolartechnik ausgeführt.

Der nichtinvertierende Eingang 1 eines solchen Verstärkers steuert die Basis eines pnp-Transistors t4, dessen Kollektor am Bezugspotential $-V_S$ und dessen Emitter an der Kathode einer Diode d2 und über diese Diode d2 an der Basis eines zweiten pnp-Transistors t3 liegt. Der invertierende Eingang 2 entspricht in seiner Schaltung der des nichtinvertierenden Eingangs 1. Er bildet also den Basisanschluß eines dritten pnp-Transistors t1, dessen Kollektor ebenfalls am Bezugspotential $-V_S$ und dessen Emitter an der Kathode einer Diode d1 und über diese Diode d1 an der Basis eines vierten pnp-Transistors t2 liegt.

Der Emitter des zweiten pnp-Transistors t3 ist über die Reihenschaltung zweier einander gleicher Widerstände r2, r1 mit dem Emitter des vierten pnp-Transistors t2 verbunden. Außerdem liegt der Verbindungspunkt zwischen den beiden Widerständen r1 und r2 über eine Konstantstromquelle i1 an der Klemme für den Anschluß des Versorgungspotentials $+V_S$, während das Bezugspotential $-V_S$ für den ersten pnp-Transistor t4 und den dritten pnp-Transistor t1 von der Klemme f der integrierten Schaltung IS nach Fig. 2 abgenommen wird.

Der zweite pnp-Transistor t3 ist mit seinem Kollektor mit dem Kollektor eines ersten npn-Transistors t6 verbunden. Dessen Basis ist an die Basis und den Kollektor eines als Diode geschalteten zweiten npn-Transistors t5 und den Kollektor des vierten pnp-Transistors t2 angeschlossen. Die Emitter der Transistoren t5 und t6 liegen ebenfalls über die Anschlußklemme f am Bezugspotential $-V_S$ für die integrierte Schaltung.

Sowohl der Kollektor des zweiten pnp-Transistors t3 als auch der Kollektor des vierten pnp-Transistors t2 steuern die Basis jeweils eines weiteren pnp-Transistors t7 und t8. Der Emitter des vom vierten pnp-Transistors t2 gesteuerten pnp-Transistors t7 liegt dabei über eine Sromquelle i2 ander Klemme für das Versorgungspotential $+V_S$ und mit einem Kollektor an der Klemme f mit dem Bezugspotential $-V_S$. Der

Emitter des vom zweiten pnp-Transistors t3 gesteuerten pnp-Transistors t8 liegt über eine weitere Stromquelle i3 an der Klemme für das Versorgungspotential $+V_S$ und mit seinem Kollektor an der bereits angeführten Klemme f. Im Unterschied gegenüber den pnp-Transistor t7 liegt jedoch der Emitter des pnp-Transistors t8 auch an der Basis eines dritten npn-Transistors t9, während für den Transistor t7 keine weitere Verbindung vorgesehen ist.

Die Emitter-Kollektorstrecke des zuletzt eingeführten dritten npn-Transistors t9 ist von der Serienschaltung zweier gleichsinnig gepolter Dioden d3 und d4 und der Basis-Kollektordiode eines vierten npn-Transistors t10 überbrückt. Hierzu liegt der Kollektor des dritten npn-Transistors t9 einerseits über eine vierte Konstantstromquelle i4 an der Klemme für das Versorgungpotential $+V_S$ und andererseits an der Anode der Diode d3. In Reihe zur Diode d3 und mit ihr gleichsinnig gepolt liegt die Diode d4, deren Kathode mit dem Kollektor des vierten npn-Transistors t10 verbunden ist. Die Basis des vierten npn-Transistors t10 liegt am Emitter des dritten npn-Transistors t9, sein Emitter an der Anschlußklemme f. Der Kollektor des Transistors t10 ist mit der Basis eines siebenten pnp-Transistors t15 verbunden.

Andererseits ist der Kollektor des dritten npn-Transistors t9 an die Basis eines fünften npn-Transistors t13 angeschlossen. Dieser Transistor t13 bildet zusammen mit einem sechsten npn-Transistor t14 einen emittergekoppelten Differenzverstärker, dessen beide Emitter über eine fünfte Stromquelle i5 an die bereits mehrfach erwähnte Anschlußklemme f und an das Bezugspotential $-V_S$ angeschlossen ist. Der Kollektor des fünften npn-Transistors t13 liegt an der Basis und am Kollektor eines als Diode geschalteten achten pnp-Transistors t11, der mit seinem Emitter an der Klemme für das Versorgungspotential $+V_S$ angeschlossen ist und außerdem mit seiner Basis und seinem Kollektor an der Basis eines neunten pnp-Transistors t12 liegt. Dieser pnp-Transistor t12 wird ebenfalls an seinem Emitter unmittelbar durch für das Versorgungspotential $+V_S$ beaufschlagt und ist mit seinem Kollektor unmittelbar mit dem Kollektor und der Basis des als Diode geschalteten sechsten npn-Transistors t14 verbunden.

Zur Ausgangsstufe des Operationsverstärkers gehören zwei weitere npn-Transistoren t16 und t17, die bezüglich ihrer Emitter-Kollektorstrecke in Reihe geschaltet sind. Dabei liegt der Kollektor des siebenten npn-Transistors t16 an der Klemme für das Versorgungspotential $+V_S$ und sein Emitter am Signalausgang 3 des betreffenden Operationsverstärkers. Andererseits ist der Emitter des achten npn-Transistors t17 entsprechend der Lehre der DE-OS 32 35 289 direkt über eine nichtbezeichnete Klemme mit der Klemme für den Anschluß des Bezugspotentials $-V_S$ verbunden. Der Kollektor des achten npn-Transistors t17 ist unmittelbar mit dem Signalausgang 3 des Operationsverstärkers verbunden, seine Basis liegt über einem Widerstand r5 am Emitter des Transistors t17 und an der nicht näher bezeichneten Klemme für den Anschluß des Bezugspotentials −V$_S$. Außerdem liegt die Basis des npn-Transistors t17 am Kollektor des siebenten pnp-Transistors t15, der ebenfalls noch zur Endstufe gehört.

Auch die Basis des siebenten npn-Transistors t16 ist über einen Widerstand r4 mit dem Emitter dieses Transistors t16 und dem Signalausgang 3 des Operationsverstärkers sowie dem Emitter des siebenten pnp-Transistors t15 verbunden. Außerdem liegt die Basis des siebenten npn-Transistors t16 am Kollektor und der Basis des sechsten npn-Transistors t14. Schließlich ist der Signalausgang 3 des Operationsverstärkers über einen Widerstand r3 mit den Emittern des fünften bzw. des sechsten npn-Transistors t13 bzw. t14 verbunden.

Die Ausgestaltung eines Operationsverstärkers nach Fig. 3 bietet folgende Vorteile:

Die Dioden d1 und d2 stellen sicher, daß der Gleichtaktbereich der Eingangsklemmen 1 und 2 des Operationsverstärkers bis auf das Bezugspotential −V$_S$ reicht.

Eine Offsetminimierung erreicht man dadurch, daß die Basisströme der Transistoren t5 und t6 für die typische Stromverstärkung über das Emitter-Flächen-Verfhältnis dieser Transistoren kompensiert werden und daß der Basisstrom des pnp-Transistors t8 durch den Basisstrom des pnp-Transistors t7 compensiert wird, dessen Kollektorstrom gleich dem Kollektorstrom von t8 ist.

Andererseits ist es aber auch möglich, wie in Fig. 2 die zur Anschlußklemme f führende Leitung direkt auf die nicht näher bezeichnete Klemme zum Anschluß des Bezugspotentials −V$_S$ zu legen. Da jedoch der Strom durch die Ausgangsstufe des Operationsverstärkers alle anderen Ströme der integrierten Verstärkerschaltung um Größenordnungen übertrifft, führt dies dann zu einer Verkopplung des Vorstufenstromes mit dem Endstufenstrom aufgrund der parasitären Eigenschaften des Operationsverstärkers. Diese Verkopplung führt zu einer störenden Erhöhung des Klirrfaktors der Verstärkerschaltung, die sich vor allem beim Einsatz einer solchen Schaltung als Ausgangsverstärker für Rundfunk- und Fernsehzwecke bemerkbar macht. Neben der Endkopplung bietet die Schaltung nach Fig. 3 den weiteren Vorteil, daß der nicht näher bezeichnete Anschluß mit der Kühllasche des integrierten Schaltkreises leitend verbunden und diese zum Anschluß des Bezugspotentials −V$_S$ des Operationsverstärkers vorgesehen werden kann.

Die Ausgangsleistungen der Verstärkerschaltung IS nach Fig. 2 betragen ca. 15 W bei einem Lastwiderstand R$_L$ von 4 Ohm und einer Versorgungsspannung von 14,4 V bzw. etwa 30 W bei einem Lastwiderstand R$_L$ von 8 Ohm bei einer Versorgungsspannung von 25 V.

Um der hohen Ausgangsleistung der erfindungsgemäßen integrierten Verstärkerschaltung IS nach Fig. 2 weitere Anwendungsgebiete zu erschließen, zeigt Fig. 4 die Verwendung der integrierten Verstärkerschaltung in einem Stereoverstärker. Dabei sind wiederum gleiche Elemente wie in Fig. 2 und 1 mit gleichen Bezugzeichen versehen. Das mit einem Verstärkersymbol gekennzeichnete Element 2IS enthält dabei zweimal die in Fig. 2 dargestellte integrierte Verstärkerschaltung IS mit folgenden Besonderheiten:

Beide Teilschaltungen nach Fig. 2 werden über zwei nicht näher bezeichnete Anschlußklemmen mit Spannung versorgt, die den beiden Teilschaltungen über den interne Verbindung iV zugeführt wird.

Die Fußpunkte der ohmschen Spannungteiler beider Teilschaltungen werden zu einem gemeinsamen ersten Knotenpunkt geführt, der mit einer Anschlußklemme f verbunden wird.

Die heruntergeteilten Versorgungspotentiale V$_P$ beider Teilschaltungen werden zu einem gemeinsamen Knotenpunkt geführt, der mit einer einzigen Klemme e verbunden wird.

Für die Ableitung des heruntergeteilten Versorgungspotentials V$_P$ genügt ein ohmscher Spannungteiler aus R3 und R4 und ein Zwischenwiderstand R8.

Zur Siebung des geteilten Versorgungspotentials V$_P$ wird die Anschlußklemme e über einen einzigen Kondensator K mit dem Bezugspotential −V$_S$ verbunden.

Die siebung dem Versorgungsspannung erfolgt wie in Fig. 2 mit Hilfe der beiden Siebkondensatoren C$_{S1}$ und C$_{S2}$.

Alle übrigen Elemente der Verstärkerschaltung 2IS und ihrer Außenbeschaltung entsprechen einer Verdopplung der Teilschaltung nach Fig. 2. Dabei sind die Eingänge und die Ausgänge entsprechend der Fig. 2 bezeichnet, wobei die tiefgestellte Ziffer die jeweilige Teilschaltung kennzeichnet. Die von den jeweiligen Ausgangsklemmen zum Bezugspotential −V$_S$ liegende Serienschaltung aus einem Kondensator und einem Widerstand ist in den Teilelementen durchgehend mit tiefgestellten Ziffern von 1 bis 4 bezeichnet.

Die Stereoverstärkerschaltung 2IS nach Fig. 4 kommt allerdings nicht mehr mit sieben Anschlußpins aus, da zwei Ausgänge und ein Eingang zusätzlich benötigt werden. Deshalb ist in diesem Fall wiederum ein Sondergehäuse notwendig, allerdings bietet die Stereoverstärkerschaltung 2IS gegenüber dem Stand der Technkk eine erheblich höhere Ausgangsleistung.

**Patentansprüche**

1. Integriete Verstärkerschaltung
mit einem ersten und einem zweiten Operationsverstärker mit jeweils einem invertierenden und einem nichtinvertierenden Eingang, je einem Ausgang sowie Verbindungen zu Knotenpunkten für den Anschluß eines Versorgungs- und eines Bezugspotentials,
mit jeweils einer reellen Gegenkopplung der beiden Operationsverstärker aus einem aus zwei Widerständen bestehenden, vom Ausgang zu einem ersten Knotenpunkt geschalteten ohm-

schen Spannungsteiler und einem von dessen Teilpunkt zum invertierenden Eingang des betreffenden Operationsverstärkers liegenden weiteren ohmschen Widerstand,

mit einem weiteren, zwischen den Knotenpunkt für den Anschluß des Versorgungspotentials und den ersten Knotenpunkt geschalteten ohmschen Spannungsteiler aus zwei Widerständen, dessen Teilpunkt über einen ohmschen Zwischenwiderstand mit einem zweiten Knotenpunkt und dieser wiederum über je einen ohmschen Versorgungswiderstand mit den nichtinvertierenden Eingängen der beiden Operationsverstärker verbunden ist,

mit einem am invertierenden Eingang des ersten Operationsverstärkers liegenden ohmschen Vorwiderstand und

mit Klemmen zur Einspeisung eines Signals, zur Abnahme zweier Signale an den Ausgängen der Operationsverstärker, zur Verbindung der Knotenpunkte für den Anschluß des Versorgungs- und Bezugspotentials mit einer Versorgungsspannungsquelle und zum Anschluß des ersten und zweiten Knotenpunkts, gekennzeichnet durch eine einzige, mit dem Vorwiderstand (R7) und dem nichtinvertierenden Eingang (+) des zweiten Operationsverstärkers (VR) verbundene Klemme (h) zur Einspeisung eines Signals und durch eine gegenüber dem jeweiligen Versorgungswiderstand (R5, R5') erheblich höhere, im wesentlichen rein reelle Eingangsimpedanz der beiden Operationsverstärker (VL, VR) im niederfrequenten Bereich.

2. Integrierte Verstärkerschaltung nach Anspruch 1, dadurch gekennzeichnet, daß die beiden Operationsverstärker (VL, VR) im Aufbau und einschließlich ihrer Gegenkopplungs- und Versorgungswiderstände (R1, R2, R6, R5, R1', R2', R6', R5') in der Dimmensionierung gleich sind.

3. Integrierte Verstärkerschaltung nach Anspruch 1 oder 2, dadurch gekennzeichnet, daß der Wert des weiteren ohmschen Widerstandes (R6, R6') der Gegenkopplungen der beiden Operationsverstärker (VL, VR) gleich der Summe des Wertes des ohmscen Versorgungswiderstandes (R5, R5') und des doppelten Wertes des ohmschen Zwischenwiderstandes (R8) ist.

4. Integrierte Verstärkerschaltung nach Anspruch 1 bis 3, dadurch gekennzeichnet, daß die Werte der weiteren ohmschen Widerstände (R6, R6') der Gegenkopplungen der beiden Operationsverstärker (VL, VR) und des ohmschen Vorwiderstandes (R7) des ersten Operationsverstärkers (VL) einander gleich sind.

5. Integrierte Verstärkerschaltung nach Anspruch 1 bis 4, dadurch gekennzeichnet, daß der erste Knotenpunkt Bezugspunkt der ohmschen Spannungsteiler ist und mit Hilfe seiner Anschlußklemme (f) an das Bezugspotential ($-V_s$) der Versorgungsspannungsquelle angeschlossen wird.

6. Integrierte Verstärkerschaltung nach Anspruch 1 bis 5, dadurch gekennzeichnet, daß der Knotenpunkt für den Anschluß des Bezugspotentials ($-V_s$) mit Bezugspunkten von Ausgangsstufen der Operationsverstärker (VL, VR) verbunden ist und der an das Bezugspotential ($-V_s$) der Versorgungsspannungsquelle anzuschließende erste Knotenpunkt gleichzeitig Bezugspunkt der ohmschen Spannungsteiler (R1, R2; R1', R2'; R3, R4) und von Eingangsstufen der Operationsverstärker ist und

daß keine interne leitende Verbindung zwischen beiden Knotenpunkten und ihren Anschlußklemmen (f, nicht bezeichnet) vorhanden ist.

7. Integrierte Verstärkerschaltung nach Anspruch 1 bis 6, dadurch gekennzeichnet, daß die mit dem Knotenpunkt für den Anschluß des Bezugspotentials ($-V_s$) verbundene Klemme (nicht bezeichnet) als Kühllasche ausgebildet ist.

8. Verwendung einer integrierten Verstärkerschaltung nach einem der Ansprüche 1 bis 7 in einer Stereoverstärkerschaltung, gekennzeichnet durch doppelte Ausführung der integrierten Verstärkerschaltung (IS) in einem Gehäuse (2IS).

9. Verwendung einer integrierten Verstärkerschaltung nach einem der Ansprüche 1 bis 7 in einer Stereoverstärkerschaltung nach Anspruch 8, dadurch gekennzeichnet, daß die ersten und zweiten Knotenpunkte und die Knotenpunkte für den Anschluß des Versorgungs- und Bezugspotentials ($+V_s$, $-V_s$) jeweils zusammengelegt sind und jeweils nur eine Anschlußklemme (f, e, nicht bezeichnet) aufweisen und daß der weitere ohmsche Spannungsteiler (R3, R4) und der ohmsche Zwischenwiderstand (R8) einfach ausgeführt und beiden integrierten Teilschawtungen gemeinsam sind.

10. Verwendung einer integrierten Verstärkerschaltung nach einem der Ansprüche 1 bis 7 in einer Stereoverstärkerschaltung nach Anspruch 8 oder 9, dadurch gekennzeichnet, daß die Stereoverstärkerschaltung auf einem Chip in einem Gehäuse untergebracht ist.

**Revendications**

1. Circuit amplificateur intégré comportant:

des premier et second amplificateurs opérationnels comportant chacun une entrée inverseuse et une entrée non inverseuse, et une sortie, ainsi que des liaisons à des noeuds pour le raccordement d'un potentiel d'alimentation et d'un potentiel de référence,

respectivement une contre-réaction réelle des deux amplificateurs opérationnels, formée par un diviseur ohmique de tension constitué par deux résistances et branché entre la sortie et un premier noeud, et par une autre résistance ohmique branchée entre le point de division du diviseur de tension de l'entrée inverseuse de l'amplificateur opérationnel considéré,

un autre diviseur ohmique de tension branché entre le noeud prévu pour le raccordement du potentiel d'alimentation et le premier noeud, et constitué par deux résistances, avec le point de division relié par une résistance ohmique intermédiaire à un second noeud, ce dernier étant relié à nouveau, respectivement par l'intermédiaire d'une résistance ohmique d'alimentation, aux entrées non inverseuses des deux amplificateurs opérationnels,

une résistance ohmique additionnelle raccordée à l'entrée inverseuse du premier amplificateur opérationnel, et

des bornes pour introduire un signal, prélever deux signaux sur les sorties des amplificateurs opérationnels, relier les noeuds prévus pour le raccordement du potentiel d'alimentation et du potentiel de référence à une source de tension d'alimentation et pour relier les premier et second noeuds,

caractérisé par une seule borne (h) reliée à la résistance additionnelle (R5) et à l'entrée non inverseuse (+) du second amplificateur opérationnel (VR) et servant à introduire un signal, et par une impédance d'entrée essentiellement purement réelle, nettement supérieure à la résistance respective d'alimentation (R5, R5'), des deux amplificateurs opérationnels (VL, VR) dans la plage des basses fréquences.

2. Circuit amplificateur intégré selon la revendication 1, caractérisé en ce que les deux amplificateurs opérationnels (VL, VR) possèdent une constitution identique et les valeurs de leurs résistances de contre-réaction et d'alimentation (R1, R2, R6, R5, R1', R2', R6', R5') sont identiques.

3. Circuit amplificateur intégré suivant la revendication 1 ou 2, caractérisé par le fait que la valeur de l'autre résistance ohmique (R6, R6') des contre-réactions des deux amplificateurs opérationnels (VL, VR) est égale à la somme de la valeur de la résistance ohmique d'alimentation (R5, R5') et du double de la valeur de la résistance ohmique intermédiaire (R8).

4. Circuit amplificateur intégré suivant les revendications 1 à 3, caractérisé par le fait que les valeurs des autres résistances ohmiques (R6, R6') des contre-réactions des deux amplificateurs opérationnels (VL, VR) et de la résistance ohmique additionnelle (R6) du premier amplificateur opérationnel (VL) sont identiques.

5. Circuit amplificateur intégré suivant les revendications 1 à 4, caractérisé par le fait que le premier noeud est le point de référence du diviseur ohmique de tension et est raccordé, par sa borne de raccordement (f), au potentiel de référence ($-V_s$) de la source de tension d'alimentation.

6. Circuit amplificateur intégré suivant les revendications 1 à 5, caractérisé par le fait que le noeud pour le raccordement du potentiel de référence ($-V_s$) est relié à des points de référence d'étages de sorte des amplificateurs opérationnels (VL, VR) et que le premier noeud, qui doit être raccordé du potentiel de référence ($-V_s$) de la source de tension d'alimentation constitue simultanément le point de référence du diviseur ohmique de tension (R1, R2; R1', R2'; R3, R4) et d'étages d'entrée des amplificateurs opérationnels, et qu'aucune liaison conductrice interne n'est présente entre les deux noeuds et leurs bornes de sortie (f), non désignée.

7. Circuit amplificateur intégré suivant les revendications 1 à 6, caractérisé par le fait que la borne (non désignée) reliée au noeud prévu pour le raccordement du potentiel de référnece ($-V_s$) est réalisée sous la forme d'une connexion froide.

8. Utilisation d'un circuit amplificateur intégré suivant l'une des revendications 1 à 7 dans un circuit amplificateur stéréo, caractérisée par le montage de deux circuits amplificateurs intégrés (IS) dans un boîtier (2IS).

9. Mise en oeuvre d'un circuit amplificateur intégré suivant l'une des revendications 1 à 7 dans un circuit amplificateur stéréo suivant la revendication 8, caractérisée par le fait que les premier et second noeuds et les noeuds pour le raccordement du potentiel d'alimentation et du potentiel de référence ($+V_s$, $-V_s$) sont interconnectés et possèdent chacun seulement une borne de raccordement (f,e, non désignée), et que l'autre diviseur de tension (R3, R4) et la résistance ohmique intermédiaire (R8) sont prévus en un exemplaire et que les deux circuits partiels intégrés sont communs.

10. Mise en oeuvre d'un circuit amplificateur intégré suivant l'une des revendications 1 à 7 dans un circuit amplificateur stéréo suivant l'une des revendications 8 ou 9, caractérisé par le fait que le circuit amplificateur stéréo est disposé sur une microplaquette dans un boîtier.

**Claims**

1. Integrated amplifier circuit,

having a first and a second operational amplifier having in each case one inverting and one non-inverting input, in each case one output and connections to circuit nodes for the connection of a supply and a reference potential,

having in each case one real negative feedback of the two operational amplifiers formed by an ohmic voltage divider, consisting of two resistors and connected from the output to a first circuit node, and a further ohmic resistor located between the dividing point of said voltage divider and the inverting input of the relevant operational amplifier,

having a further ohmic voltage divider, connected between the circuit node for the connection of the supply potential and the first circuit node, consisting of two resistors, the dividing point of said voltage divider being connected via an ohmic intermediate resistor having a second circuit node and the latter in turn being connected in each case via one ohmic supply resistor to the non-inverting inputs of the two operational amplifiers,

having an ohmic series resistor connected to the inverting input of the first operational amplifier and

having terminals for feeding in a signal, for tapping off two signals at the outputs of the operational amplifiers, for connecting the circuit nodes for the connection of the supply and reference potential to a supply voltage source and for the connection of the first and second circuit node, characterized by a single terminal (h), connected to the series resistor (R7) and the non-inverting input (+) of the second operational amplifier (VR), for feeding in a signal, and by an input impedance which is considerably higher than the respective supply resistor (R5, R5') and is essentially solely real, of the two operational amplifiers (VL, VR) in the low-frequency range.

2. Integrated amplifier circuit according to Claim 1, characterized in that the two operational amplifiers (VL, VR) are identical in construction and dimensioning and with respect to their negative feedback resistors and supply resistors (R1, R2, R6, R5, R1', R2', R6', R5').

3. Integrated amplifier circuit according to Claim 1 or 2, characterized in that the value of the further ohmic resistor (R6, R6') of the negative feedbacks of the two operational amplifiers (VL, VR) is equal to the sum of the value of the ohmic supply resistor (R5, R5') and of twice the value of the ohmic intermediate resistor (R8).

4. Integrated amplifier circuit according to Claims 1 to 3, characterized in that the values of the further ohmic resistors (R6, R6') of the negative feedbacks of the two operational amplifiers (VL, VR) and of the ohmic series resistor (R7) of the first operational amplifier (VL) are identical to one another.

5. Integrated amplifier circuit according to Claims 1 to 4, characterized in that the first circuit node is reference point of the ohmic voltage dividers and is connected with the aid of its connected terminal (f) to the reference potential ($-V_s$) of the supply voltage source.

6. Integrated amplifier circuit according to Claims 1 to 5, characterized in that the circuit node for the connection of the reference potential ($-V_s$) is connected to reference points of output stages of the operational amplifiers (VL, VR) and the first circuit node to be connected to the reference potential ($-V_s$) of the supply voltage source is at the same time reference point of the ohmic voltage dividers (R1, R2; R1', R2'; R3, R4) and of input stages of the operational amplifiers and in that there is no internal conductive connection present between the two circuit nodes and their connection terminals (f, not designated).

7. Integrated amplifier circuit according to Claims 1 to 6, characterized in that the terminal (not designated) connected to the circuit node for the connection of the reference potential ($-V_s$) is constructed as a cooling strap.

8. Use of an integrated amplifier circuit according to one of Claims 1 to 7 in a stereo amplifier circuit, characterized by the presence in duplicate of the integrated amplifier circuit (IS) in a case (2IS).

9. Use of an integrated amplifier circuit according to one of Claims 1 to 7 in a stereo amplifier circuit according to Claim 8, characterized in that the first and second circuit nodes and the circuit nodes for the connection of the supply potential and of the reference potential ($+V_s$, $-V_s$) are combined in each case and only have one connection terminal (f, e, not designated) in each case and in that the further ohmic voltage divider (R3, R4) and the ohmic intermediate resistor (R8) are of simple construction and are common to the two integrated subcircuits.

10. Use of an integrated amplifier circuit according to one of Claims 1 to 7 in a stereo amplifier circuit according to Claim 8 or 9, characterized in that the stereo amplifier circuit is disposed on a chip in a case.

FIG 1

FIG 4

# FIG 2

# FIG 3